## Europäisches Patentamt

## European Patent Office

## Office européen des brevets

(19)

(11) Veröffentlichungsnummer: **0 090 161**
**B1**

(12) **EUROPÄISCHE PATENTSCHRIFT**

(45) Veröffentlichungstag der Patentschrift:
05.11.86

(51) Int. Cl.⁴: **H 01 L 27/10,** G 11 C 11/24,
**H 01 L 21/76**

(21) Anmeldenummer: **83101406.3**

(22) Anmeldetag: **14.02.83**

(54) **Verfahren zum Herstellen von dynamischen Halbleiter-Speicherzellen mit wahlfreiem Zugriff (RAM) nach der Doppel-Polysilizium-Gate-Technologie.**

(30) Priorität: **18.02.82 DE 3205858**

(43) Veröffentlichungstag der Anmeldung:
**05.10.83 Patentblatt 83/40**

(45) Bekanntmachung des Hinweises auf die Patenterteilung:
**05.11.86 Patentblatt 86/45**

(84) Benannte Vertragsstaaten:
**AT DE FR GB IT**

(56) Entgegenhaltungen:
**US-A-4 112 575**

**PATENT ABSTRACTS OF JAPAN, Band 5, Nr. 159 (E-77)(831), 14 Oktober 1981**

(73) Patentinhaber: **Siemens Aktiengesellschaft Berlin und München, Wittelsbacherplatz 2, D-8000 München 2 (DE)**

(72) Erfinder: **Müller, Wolfgang, Dr., Theodor- Heuss-Strasse 12, D-8011 Putzbrunn (DE)**

EP 0 090 161 B1

## Beschreibung

Die vorliegende Patentaneldung betrifft ein Verfahren zum Herstellen von dynamischen Halbleiter-Speicherzellen mit wahlfreiem Zugriff (RAM = random access memory) nach der Doppel-Polysilizium-Gate-Technologie mit einer ersten, auf dem Halbleiterkörper isoliert aufgebrachten ersten, auf dem Halbleiterkörper isoliert aufgebrachten Polysiliziumebene als Speicherelektrode für die im Halbleiterkörper erzeugten Speicherbereiche und einer, von der ersten Polysiliziumebene isoliert aufgebrachten zweiten Polysiliziumebene als Wortleitungen, bei dem die Isolation benachbarter aktiver Bereichs durch Dickoxidbereiche nach der bekannten LOCOS (= local oxidation of silicon)-Technologie erfolgt und bei dem zur Erhöhung der Zellkapazität in dsn Speicherbereich unter Verwendung einer Potolackmaske eine flache Arsen- und eine tiefe Bor-Ionenimplantation durchgeführ wird.

Der Doppel-Polysilizium-Gats (Si2-Gate)-Prozeß ist als Standardprozeß für die Realisierung von dynamischen RAM-Speichern anzusehen. Ein solcher Prozeß für die Herstellung eines dynamischen 16.384-Bit-Speichers mit wahlfreiem Zugriff ist aus dem IEEE Journal of Solid-State Circuits, Vol. Sc. 11, Oktober1976, Seite 570 bis 573 zu entnehmen.

Mit der derzeit erreichbaren Strukturauflösung der Fotolithographie von etwa 1,5 µm wurde, wie aus dem Tagungsband ISSCC 15. Februar 1980 Digest of Techn. Papers, Seite 232/233 zu entnehmen ist, bereits eine 256-K-dynami-sche RAM-Speicherzelle realisiert. Die Isolation zwischen benachbarten aktiven Bereichen (Transistoren, Speicherkondensatoren, diffundierten Zonen) wird hierbei durch Dickoxidbereiche der sogenannten LOCOS-Technologie realisiert. Das LOCOS-Verfahren (= local oxidation of silioon) ist ein Isolationsverfahren für integrierte Schaltungen mit hoher Packungsdichte. Als Isoliermaterial zwischen den aktiven Bereichen wird Siliziumdioxid ($SiO_2$) verwendet. Nach selektiver Abscheidung einer Oxid- und einer Nitrid-Schicht erfolgt eine lokale Oxidation in der nitridfreien Zone, wobei eine starke laterale Unteroxidation (sogenannter Vogelschnabel, birds beak) und eine starke laterale Ausdiffusion der Feldimplantation, welche eine starke Weitenabhängigkeit der Einsatzspannung schnaler Transistoren zur Folge hat, stattfindet. LOCOS-Prozesse dieser Art sind aus den Philips-Research Reports, Vol. 26, Nr. 3, Juni 1971, auf den Seiten 157 bis 165 beschrieben. Bei dieser Isolationstechnik kann - wegen der graduellen Übergänge zwischen Dickoxid- und Dünoxidbereichen (Vogelschnabel) von etwa 0,5 µm Längs - für den Isolationsabstand nicht die minimale Strukturabmessung realisiert werden. Der minimal mögliche Isolationsabstand der LOCOS-Isolation liegt deshalb um die doppelte Vogelschnabellänge über dem minimalen Strukturmaß. Daraus folgt, daß im Falle der aus dem Tagungsband ISSCC 1980 bekannten 256 K-RAM-Speicherzelle ein zusätzlichsr Platzbedarf von etwa 25 % der Zeilfläche erforderlich ist. Der höhere Platzbedarf für den Isolationsbersich führt zu einer Vergrößerung der Gesamtchipfläche. Eine weitere prinzipielle Schwierigkeit bei der Reduktion des Isolationsabstandes ergibt sich durch den sogenannten Kurzkanaleffekt des Dickoxidtransistors. Für Isolationsabstands kleiner als 2,5 µm verliert der Dickoxidtransistor an Sperrfähigkeit.

In einem Aufsatz von Tasch aus dem IEEE Journal of Electron Devices ED 25 (1978) Seite 33, wird ein HiC (high capacity)-RAM-Zellenkonzept vorgeschlagen, wobei in den Speicherbereich zur Erhöhung der Zellkapazität eine flache Arsen- und eine tiefe Bor-Ionenimplantation durchgeführt wird. Mit einer solchen Doppelimplantation wird die Zellkapazität einer 256 K-Speicherzelle um etwa 25 % erhöht.

Die Aufgabe, die der Erfindung zugrundeliegt, besteht nun darin, dynamische RAM-Speicherzellen mit Doppel-Polysilizium-Gate-Technologie in Richtung Verkleinerung des Flächenbedarfs, Vereinfachung des technologischen Prozesses und Verbesserung der elektrischen Isolation zwischen benachbarten Zellen und damit einer Erhöhung der Spannungsfestigteit herzustellen.

Diese Aufgabe wird durch ein Verfahren der eingangs genannten Art erfindungsgemäß dadurch gelöst, daß die Dicke des Oxids im Sperrbereich an den Übergängen zwischen Dickoxidbereich und Dioxidbereich unter Verwendung der für die Arsen- und Bor-Ionenimplantation vorgesehenen Fotolackmaske durch Ätzen sowohl axial als auch lateral reduziert wird, wobei die Fotolack-Kante in die Mitte des Dickoxidbereichs gelegt wird.

Es liegt im Rahmen der Erfindung die Verfahrensschritte wie folgt durchzuführen:

a) Herstellen von Isolationsbereichen in Form von strukturierten $SiO_2$-Schichten auf dem Halbleiterkörper zur Trennung der aktiven Bereiche nach dem sogenannten LOCOS- oder Isoplanarverfahren, wobei unmittelbar vor der LOCOS-Oxidation nach Maskierung der aktiven Bereiche mit einer Siliziun-Nitridmaske eine ganzflächige Bor-Ionenimplantation zur Einstellung der Einsatzspannung der Isolationsbereiche durchgeführt wird,

b) Entfernung der Silizium-Nitridmaske und Durchführung eines ganzflächigen Oxidationsprozesses,

c) Aufbringen einer Fotolackmaske, wobei die Fotolack-Kante in die Mitte des Isolationsbereiches zwischen Speicherzelle und Dickoxid-Transistor gelegt wird,

d) Abätzen des Oxids im Dickoxid- und Dünnoxidbereich auf eine Dicke des Dünnoxidbereichs im Speicherbereich von kleiner 30. nm,

e) Erzeugung der Speicherbereiche durch eine Bor- und Arsen-Ionenimplantation, wobei die

Bor-Ionenimplantation so geführt wird, daß sie den freiliegenden Dickoxidbereich durchdringt und die Bor-Dotierung unter dem Dickoxid erhöht und die Arsen-Ionenimplantation so durchgeführt wird, daß sie nur in aktiven Speicherbereich wirksam wird,

f) Abätzen der nicht mit der Fotolackmaske abgedeckten Oxidschicht auf einen Wert, der etwa 2/3 der Ausgangsschichtdicke des Isolationsoxids entspricht,

g) Entfernen der Fotolackmaske und ganzflächiges Abätzen der Oxidschichtoberfläche um weitere 100 nm,

h) Erzeugen des Gateoxids, der ersten Polysilizium-Ebene, des Isolationsoxids und der zweiten Polysilizium-Ebene, sowie der Source/Drainbereiche, des Zwischenoxids und der Kontakte in bekannter Weise.

Es ist aber auch möglich, in Abänderung dieser Verfahrensfolge, den gesamten Überätzschritt unter Verwendung der Implantation in einem einzigen Prozeß durchzuführen. Die Ionen-Implantation wird dann ohne Streuoxid durchgeführt, wobei die Energie der Bor-Ionenimplantation entsprechend zu reduzieren ist. Dies erfolgt durch Reduzierung der Implantationsenergie von 140 keV auf 100 keV.

Besondere Ausgestaltungen ergeben sich aus den Unteransprüchen.

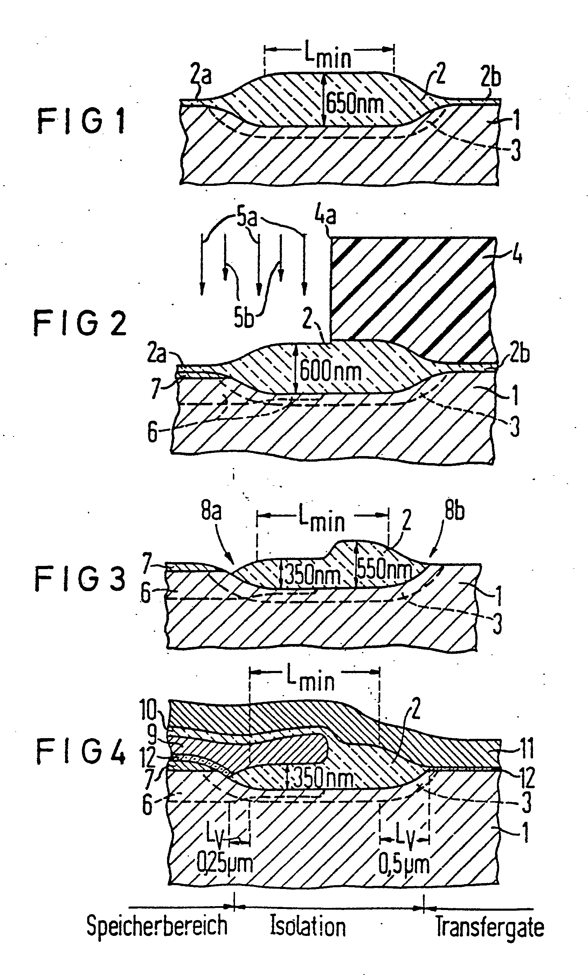

Weitere Einzelheiten und Vorteile der Erfindung sind anhand der Figuren 1 bis 4, welche den Verfahrensablauf gemäß einem Ausführungsbeispiel nach Patentanspruch 2 im Schnittbild darstellen, noch näher erläutert.

In allen Figuren gelten für gleiche Teile die gleichen Bezugszeichen.

Figur 1 zeigt einen p-dotierten Halbleiterkörper 1 (20 0hm,cm), auf den in herkömmlicher Weise nach der LOCOS-Technologie die für die Trennung der aktiven Bereiche erforderliche Dickoxidschicht 2 erzeugt worden ist. Unter den Dickoxidbereichen ist in bekannter Weise eine Bor-Dotierung als Kanalstop (Einstellung der Einsatzspannung von etwa 1 Volt) eingebracht worden, wobei Bor-Ionen mit einer Dosis von 2. $10^{12}$ cm$^{-2}$ und einer Energie von 120 keV vor der LOCOS-Oxidation unter Verwendung der Nitridmaske auf den aktiven Bereichen implantiert werden. Im folgenden ist die Bor-Feldimplantation mit dem Bezugszeichen 3 bezeichnet. Die Figur 1 zeigt den erfindungswesentlichen Teil der Anordnung nach dem Entfernen der Nitridmaske (der LOCOS-Prozeß ist, da bekannt, im einzelnen nicht dargestellt) und nach dem Aufoxidieren der Oberflächen. Die Dickoxidschicht 2 weist eine Schichtdicke von 650 nm, der Dünnoxidbereich 2a, 2b eine Schichtdicke von 75 nm auf. Der Bereich des minimalen Strukturmaßes $L_{min}$ ist über dem Schnittbild eingezeichnet.

In Figur 2 werden mit Hilfe einer implantationsmaske 4 aus Fotolack die Speicherbereiche definiert, in/dem Bor-und Arsen-Ionen 5a, 5b in den Halbleiterkörper 1 implantiert werden, wobei die Fotolackkante 4a

in die Mitte des Isolationsbereiches (2, 2a, 2b) gelegt wird. Dann wird die Oxidoberfläche abgeätzt, wobei die Dicke des freien Dünnoxidbereiches 2a auf 25 nm und die Dicke des freien Dickoxidbereiches 2 auf 600 nm reduziert wird. Nun erfolgt die sogenannte HiC-Implantation (high capacity), wobei zunächst eine tiefer liegende Bor-Implantation 5a und dann eine flache Arsen-Implantation 5b in den Speicherbereich eingebracht wird. Die Implantationsparameter der Bor-Implantation 5a werden so gewählt, daß sowohl ein maximaler Gewinn in der Speicherkapazität und eine genügend gute Spannungsfestigkeit der Speicherdiode gewährleistet ist, als auch die Implantation genügend tief eingebracht wird, so daß möglichst ein großer Teil der Bordosis den freiliegenden Dickoxidbereich 2 durchdringt und die Dotierung des Kanalstops (3) erhöht. Im Ausführungsbeispiel wird die Implantationsdosis auf 7 x $10^{12}$ Bcm$^{-2}$ bei einer Energie von 140 keV eingestellt. Die nach folgende Arsen-Implantation 5b dient der Einstellung der Einsatzspannung im Speicherbereich. Wegen der geringen Eindringtiefe (Energie 100 keV, 1 x $10^{14}$ Ascm$^{-2}$) kann das Arsen den Dickoxidbereich 2 nicht durchdringen. Der implantierte Bor-Bereich ist mit dem Bezugzeichen 6, der implantierte Arsen-Bereich mit 7 bezeichnet.

Figur 5: Im nächsten Verfahrensschritt werden nun die freiliegenden Dick- und Dünnoxidbereiche (2, 2a) um 150 nm überätzt, wodurch die Vogelschnabellänge (siehe Pfeil 8) auf etwa 0,3 µm reduziert wird. Die Fotolackmaske 4 wird entfernt und eine ganzflächige Überätzung der Oberfläche um 100 nm angeschlossen. Dadurch wird der Vogelschnabel 8a des Speicherbereiches auf etwa 0,25 µm bei 350 nm Feldoxiddicke reduziert. Für ein typisches 256 K-Zeildesign entspricht dies einem Gewinn von 25 % in der Speicherfläche. Der Vogelschnabel (8b) der übrigen aktiven Bereiche beträgt etwa 0,5 µm. Das Isolationsverhalten des gedünnten Feldoxidbereiches (2) ist wegen der erhöhten Bordotierung wesentlich besser als das der ungedünnten Bereiche (Stand der Technik). Durch das erfindungsgemäße Verfahren wird ein Gewinn in der Sperrspannung von mehr als 10 V erreicht.

Wie aus Figur 4 zu entnehmen ist, ergibt sich als weiterer Vorteil des erfindungsgemäßen Verfahrens eine verbesserte Planarität der Bauelemente durch Versenken des Poly-silizium-1-Dickoxidüberlapps. In der Figur 4 ist die Anordnung nach Durchführung der Gateoxidation (12), Aufbringen und Strukturierung der Polysilizium-1-Elektrode 9, Erzeugen des Isolationsoxids 10 und Aufbringen/Strukturieren der Polysilizium-2-Elektrode 11 dargestellt. Der Figur 4 sind ebenfalls die minimalen Strukturmaße $L_{min}$ sowie die Vogelschnabellänge $L_V$ zu entnehmen. In der Figur 4 ist auch der aktive Speicherbereich der Zelle, der Bereich eines Auswahltransistors und der Isolationsbereich durch Doppel- bzw. Richtungspfeile markiert.

Als Ätzverfahren für das Dünnen der Isolationsschichten können naßchemische Ätzverfahren (z. B. gepufferte Flußsäurelösungen) und auch reaktive Trockenätzverfahren, wie vorzugsweise das Plasmaätzverfahren verwendet werden.

Alternativ zu der im Ausführungsbeispiel (Figur 1 bis 4) beschriebenen Verfahrensfolge kann der gesamte Überätzschritt unter Verwendung der Fotolackmaske 4 (für die Ionenimplantationen) bei 200 nm Abtrag des Dickoxidtransistors vor der Ionenimplantation (5a, 5b) durchgeführt werden. Die Bor-/Arsen-Ionenimplantation wird dann in folgendem Schnitt ohne Streuoxid eingebracht, wobei die Energie der Borionenimplantation entsprechend reduziert

## Patentansprüche

1. Verfahren zum Herstellen von dynamischen Halbleiterspeicherzellen mit wahlfreiem Zugriff (RAM) nach der Doppel-Polysilizium-Gate-Technologie mit einer ersten, auf dem Halbleiterkörper isoliert aufgebrachten Polysilizium-Ebene (9) als Speicherelektrode für die im Halbleiterkörper (1) erzeugten Speicherbereiche und einer von der ersten Polysilizium-Ebene (9) isoliert aufgebrachten zweiten Polysilizium-Ebene (11) als Wortleitungen, bei dem die Isolation benachbarter aktiver Bereiche durch Dickoxidbereiche (2) nach der bekannten LOCOS (= local oxidation of silicon)-Technologie erfolgt und bei dem zur Erhöhung der Zellkapazität in den Speicherbereich unter Verwendung einer Fotolackmaske (4) eine flache Arsen- (7) und eine tiefe Bor-Ionenimplantation (6) durchgeführt wird, dadurch gekennzeichnet, daß die Dicke des Oxids im Speicherbereich an den Übergängen zwischen Dickoxidbereich (2) und Dünnoxidbereich (2a) unter Verwendung der für die Arsen- und Borionenimplantation (5a, 5b) vorgesehenen Fotolackmaske (4) durch Ätzen sowohl axial als auch lateral reduziert wird, wobei die Fotolackkante (4a) in die Mitte des Dickoxidbereiches (2) gelegt wird.

2. Verfahren nach Anspruch 1, gekennzeichnet durch den Ablauf folgender Verfahrensschritte:
a) Herstellen von Isolationsbereichen in Form von strukturierten SiO$_2$-Schichten (2) auf dem Halbleiterkörper (1) zur Trennung der aktiven Bereiche nach dem sogenannten LOCOS- oder Isodlanarverfahren, wobei unmittelbar vor der LOCOS-Oxidation nach Maskierung der aktiven Bereiche mit einer Silizium-Nitridmaske eine ganzfächige Bor-Ionenimplantatiion (3) zur Einstellung der Einsatzspannung der Isolationsbereiche durchgeführt wird,
b) Entfennung der Silizium-Nitridmaske und Durchführung eines ganzflächigen Oxidationsprozßses,
c) Aufbringen einer Fotolackmaske (4), wobei die Fotolack-Kante (4a) in die Mitte des Isolationsbereiches (2) zwischen Speicherzelle und Dickozid-Transistor gelegt wird,
d) Abätzen des Oxids im Dickoxid- (2) und Dünnoxidbereich (2a) auf eine Dicke des Dünnoxidbereichs (2a) im Speicherbereich von kleiner 30 nm,
e) Erzeugung der Speicherbereiche durch eine Bor- (5a) und Arsen-Ionenimplantation (5b), wobei die Bor-Ionenimplantation (5a) so geführt wird, daß sie den freiliegenden Dickoxidbereich (2, 2a) durchdringt und die Bor-Dotierung (3) unter dem Dickoxid (2) erhöht und die Arsen-Ioneplmplantation (5b) so durchgeführt wird, daß sie nur im aktiven Speicherbereich wirksan wird,
f) Abätzen der nicht mit der Fotolackmaske (4) abgedeckten Oxidschicht (2, 2a) auf einen Wert, der etwa 2/3 der Ausgangsschichtdicke des Isolationsoxids (2) entspricht,
g) Entfernen der Fotolackmaske (4) und ganzflächiges Abätzen der Oxidschichtoberfläche (2, 2a, 2b) um weitere 100 nm,
h) Erzeugen des Gateoxids (12), der ersten Polysilizium-Ebene (9), des Isolationsoxids (10) und der zweiten Polysilizium-Ebene (11), sowie der Source/Drainbereiche, des Zwischenoxids und der Kontakte in bekannter Weise.

3. Verfahren nach Anspruch 1, dadurch gekennzeichnet, daß in Abänderung der Verfahrensfolgen nach Anspruch 2 die Verfahrensschritte des Abätzens nach Verfahrensschritt d, f und g jedoch ohne Entfennung der Fotolackmaske (4) in einem Prozeßschritt vor dem Verfahrensschritt e durchgeführt wird.

4. Verfahren nach Anspruch 1 bis 3, dadurch gekennzeichnet, daß die Dicke im Dickoxidbereich (2) vor dem Aufbringen der Fotolackmaske (4) auf 650 nm und im Dünnoxidbereich (2a) auf 75 nm eingestellt wird.

5. Verfahren nach Anspruch 2, dadurch gekennzeichnet, daß die Dicke des Dünnoxids (2a) nach Verfahrensschritt d auf 25 nm eingestellt wird.

6. Verfahren nach Anspruch 2, dadurch gekennzeichnet, daß die Dicke des Dickoxidbereichs (2) nach Verfahrensschritt f und g im Bereich der Speicherzelle auf 350 nm, im Bereich des Dickoxid-Transistors auf 550 nm eingestellt wird.

7. Verfahren nach Anspruch 3, dadurch gekennzeichnet, daß das Dickoxid (2, 2a) durch Überätzen um 200 nm reduziert wird.

8. Verfahren nach Anspruch 1 bis 7, dadurch gekennzeichnet, daß zur Erzeugung der Einsatzspannung der Isolationsbereiche die Implantationsdosis auf $2 \times 10^{12}$ B cm-2 bei 120 keV eingestellt wird.

9. Verfahren nach Anspruch 1 bis 8, dadurch gekennzeichnet, daß zur Erzeugung der Speicherbereiche die Bor-Ionenimplantation (5a) auf eine Dosis im Bereich von $5 \times 10^{12}$ bis $8 \times 10^{12}$ cm-2 bei einer Energie von 140 keV und die Arsen-Ionenimplantation (5b) auf eine Dosis im Bereich

von 5 x $10^{13}$ bis 3 x $10^{14}$ cm$^{-2}$ bei einer Energie von 100 keV eingestellt wird.

10. Verfahren nach Anspruch 1 bis 9, <u>dadurch gekennzeichnet</u>, daß die Ätzprozesse auf naßchemischem Wege mittels gepufferter Flußsäurelösungen durchgeführt werden.

11. Verfahren nach Anspruch 1 bis 9, <u>dadurch gekennzeichnet</u>, daß das Atzen durch ein reaktives Trockenätzverfahren vorgenommen wird.

## Claims

1. A process for producing dynamic, semiconductor random access memory (RAM) cells in accordance with the double-polysilicon gate technology, with a first polysilicon plane (9) applied in insulated manner to the semiconductor body and which serves as storage electrode for the storage zones produced in the semiconductor body (1), and a second polysilicon plane (11) which is applied so as to be insulated from the first polysilicon plane (9) and which serves for word lines, where the insulation between adjacent, active zones is achieved by thick oxide zones (2) in accordance with known LOCOS (= local oxidation of silicon) technology, and where, in order to increase the cell capacity, a photo-lacquer mask (4) is used to carry out a shallow arsenic ion implantation (7) and a deep boron ion implantation (6) into the storage zone, <u>characterised in</u> that the thickness of the oxide in the storage zone at the junctions between the thick oxide zone (2) and the thin oxide zone (2a) is reduced by etching, both axially and laterally, using the photo-lacquer mask (4) provided for the arsenic and boron ion implantations (5a, 5b), the photo-lacquer edge (4a) being positioned in the centre of the thick oxide zone (2).

2. A process as claimed in Claim 1, <u>characterised by</u> the following sequence of process steps:

a) production of insulating zones in the form of structured SiO$_2$-layers (2) on the semiconductor body (1) in order to separate the active zones in accordance with the so-called LOCOS or isoplanar process, where, immediately prior to the LOCOS oxidation, after the masking of the active zones with a silicon nitride mask, boron ion implantation (3) is carried out over the entire surface in order to set the starting voltage of the insulating zones,

b) removal of the silicon nitride mask and carrying out of an oxidation process over the entire surface,

c) application of a photo-lacquer mask (4), the photo-lacquer edge(4a) being positioned in the centre of the insulating zone (2) between storage cell and thick oxide transistor,

d) etching away of the oxide in the thick oxide zone (2) and the thin oxide zone (2a) until the thickness of the thin oxide zone (2a) in the storage region is less than 30 nm,

e) production of the storage regions by boron ion implantation (5a) and arsenic ion implantation (5b), the boron ion implantation (5a) being carried out in such manner that it penetrates through the exposed thick oxide zone (2, 2a) and increases the boron doping (3) beneath the thick oxide (2), and the arsenic ion implantation (5b) being carried out in such manner that it is effective only in the active storage region,

f) etching away of that part of the oxide layer (2, 2a) which is not covered by the photo-lacquer mask (4) to a thickness which corresponds approximately to two-thirds of the starting layer thickness of the insulating oxide (2),

g) removal of the photo-lacquer mask (4) and etching away of.the oxide layer (2, 2a, 2b) over the entire surface by a further 100 nm,

h) production of the gate oxide (12), of the first polysilicon plane (9), of the insulating oxide (10) and of the second polysilicon plane (11), and likewise production of the source/drain zones, the intermediate oxide and the contacts in known manner.

3. A process as claimed in Claim 1, <u>characterised in</u> that as a modification of the process sequence claimed in Claim 2, the etching process steps in accordance with process steps d, f and g, but without the removal of the photo-lacquer mask (4), are carried out in a process step prior to process step e.

4. A process as claimed in Claim 1 to 3, <u>characterised in</u> that the thickness of the thick oxide zone (2) prior to the application of the photo-lacquer mask (4) is set at 650 nm, and that of the thin oxide zone (2a) is set at 75 nm.

5. A process as claimed in Claim 2, <u>characterised in</u> that the thickness of the thin oxide (2a) in accordance with process step d is set at 25 nm.

6. A process as claimed in Claim 2, <u>characterised in</u> that the thickness of the thick oxide zone (2) in accordance with process steps f and g is set at 350 nm in the region of the storage cell and at 550 nm in the region of the thick oxide transistor.

7. A process as claimed in Claim 3, <u>characterised in</u> that the thick oxide (2, 2a) is reduced by 200 nm by over-etching.

8. A process as claimed in Claim 1 to 7, <u>characterised in</u> that, in order to produce the starting voltage of the insulating zones, the implantation dose is set at 2 x $10^{12}$ 8 cm$^{-2}$ at 120 keV.

9. A process as claimed in Claim 1 to 8, <u>characterised in</u> that for the production of the storage regions, the boron ion implantation (5a) is set at a dose in the range of 5 x $10^{12}$ to 8 x $10^{12}$ cm$^{-2}$ at an energy of 140 keV, and the arsenic ion implantation (5b) is set at a dose in the range of 5 x $10^{13}$ to 8 $10^{14}$ cm$^{-2}$ at an energy of 100 keV.

10. A process as claimed in Claim 1 to 9, <u>characterised in</u> that the etching processes are carried out by a wet chemical method using buffered.hydrofluoric acid solutions.

11. A process as claimed in Claim 1 to 9, characterised in that the etching is carried out by a reactive dry etching process.

## Revendications

1. Procédé pour fabriquer des cellules de mémoire dynamiques à semiconducteurs à accès diréct (RAM) selon la technologie à double grille en polysilicium, comportant un premier plan de polysilicium (9) déposé de façon isolée sur le corps semiconducteur, sous la forme d'une électrode de mémorisation pour les zones demémoire produites dans le corps semiconducteur (1), et un second plan de polysilicium (11) déposé de façon isolée sur le premier plan de polysilicium (9) de manière à constituer des lignes de transmission de mots, et selon lequel l'isolation de zones actives voisines est réalisée au moyen de couches d'oxyde épais (2) conformément à la technologie connue LOCOS (= local-oxidation of silicons) et selon lequel, pour accroître la capacité des cellules dans la zone de mémoire on réalise, moyennant l'utilisation d'un masque de vernis photosensible (4), une implantation superficielle (7) d'ions d'arsenic et une implantation profonde (6) d'ions de bore, caractérisé par le fait qu'on réduit aussi bien axialement que latéralement, par corrosion, l'épaisseur de l'oxyde dans la zone de mémoire au niveau des jonctions entre la zone (2) d'oxyde épais et la zone (2a) d'oxyde mince moyennant l'utilisation du masque de vernis photosensible (4) prévu pour l'implantation d'ions d'arsenic et d'ions de bore (5a,5b), tout en disposant le bord (4a) du vernis photosensible au centre de la zone d'oxyde épais (2).

2. Procédé suivant la revendication 1, caractérisé par l'exécution des phases opératoires suivantes:

a) fabrication de zones isolantes sous la forme de couches structurées de $SiO_2$ (2) sur le corps semiconducteur (1) afin de séparer les zones actives, conformément audit procédé LOCOS ou Isoplanar, auquel cas directement avant l'oxydation LOCOS et après le masquage des zones actives avec un masque de nitrure de silicium, on réalise une implantation d'ions de bore (3) sur toute la surface afin de régler la tension de déclenchement des zones isolantes.

b) élimination du masque de nitrure de silicium et mise en oeuvre d'un processus d'oxydation sur l'ensemble de la surface,

c) dépôt d'un masque de vernis photosensible (4), auquel cas on dispose le bord du vernis photosensible au centre de la zone isolante (2) entre la cellule de mémoire et le transistor formé d'oxyde épais,

d) élimination, par corrosion,de l'oxyde situé dans la zone d'oxyde épais (2) et dans la zone d'oxyde mince (2a), sur une épaisseur de moins de 30 nm de la zone d'oxyde mince (2a) dans la zone de mémoire,

e) production des zones de mémoire au moyen d'une implantation d'ions de bore (5a) et d'une implantation d'ions d'arsenic (5a), l'implantation d'ions de bore (5a) étant réalisée de telle sorte qu'elle s'étend à travers la zone à nu d'oxyde épais (2,2a) et accroît le dopage en bore (3) au-dessous de l'oxyde épais (2), l'implantation d'ions d'arsenic (5b) étant réalisée de telle sorte qu'elle devient active uniquement dans la zone active de mémoire,

f) élimination, par corrosion, de la couche d'oxyde (2, 2a) non recouverte par le masque de vernis photosensible (4), jusque sur une hauteur qui correspond approximativement aux 2/3 de l'épaisseur de la couche initiale d'oxyde isolant (2),

g) élimination du masque de vernis photosensible (4) et élimination, par corrosion sur toute la surface, de la surface de la couche d'oxyde (2, 2a, 2b) sur une hauteur supplémentaire de 100 nm,

h) production, de façon connue, de l'oxyde de grille (12), du premier plan de polysilicium (9), de l'oxyde isolant (10) et du second plan de polysilicium (12) ainsi que des zones de source/drain, de l'oxyde intermédiaire et des contacts.

3. Procédé suivant la revendication 1, caractérisé par la fait qu'en variante de la séquence opératoire selon la revendication 2, les phases opératoires de l'enlèvement par corrosion conformément aux phases opératoires d, f et g, sont exécutées cependant sans suppression du masque de vernis photosensible (4) lors d'une phase opératoire intervenant avant la phase opératoire e.

4. Procédé suivant les revendications 1 à 3, caractérisé par le fait qu'on règle l'épaisseur dans la zone d'oxyde épais (2) à 650 nm et l'épaisseur dans la zone d'oxyde mince (2a) à 75 nm, avant le dépôt du masque de vernis photosensible.

5. Procédé suivant la revendication 2, caractérisé par le fait qu'on règle l'épaisseur de l'oxyde mince (2a) à 25 nm après la phase opératoire d.

6. Procédé suivant la revendication 2, caractérisé par le fait que selon les phases opératoires f et g, on règle l'épaisseur de la zone d'oxyde épais (2) à 350 nm dans la zone de la cellule de mémoire et à 550 nm dans la zone du transistor formé de l'oxyde épais.

7. Procédé suivant la revendication 3, caractérisé par le fait qu'on réduit de 200 nm l'oxyde épais (2, 2a) au moyen d'une corrosion en excès.

8. Procédé suivant les revendications 1 à 7, caractérisé par le fait que pour produire la tension de service des zones isolantes, on règle la dose d'implantation à $2 \times 10^{12}$ B. cm$^{-2}$, à 120 keV.

9. Procédé suivant les revendications 1 à 8, caractérisé par le fait que pour la production des zones de mémoire, on règle l'implantation d'ions de bore (5a) à une dose située dans la plage allant de $5 \times 10^{12}$ à $8 \times 10^{12}$ cm$^{-2}$ à une énergie de 140 keV, et l'implantation d'ions d'arsenic (5b) à une dose située dans la plage comprise entre 5 x $10^{13}$ et 3 x $10^{14}$ $cm^{-2}$, à une énergie de 100 keV.

10. Procédé suivant les revendications 1 à 9, caractérisé par le fait que les processus de corrosion sont exécutés par voie chimique humide à l'aide de solutions d'acide fluorhydrique tamponnées.

11. Procédé suivant les revendications 1 à 9, caractérisé par le fait que la corrosion est réalisée au moyen d'un procédé de corrosion réactive à sec.

FIG 1

FIG 2

FIG 3

FIG 4

Speicherbereich     Isolation     Transfergate